Europäisches Patentamt

European Patent Office

Office européen des brevets

(11) Publication number: **0 141 548 B1**

## EUROPEAN PATENT SPECIFICATION

(45) Date of publication of patent specification: 08.01.92  (51) Int. Cl.⁵: **G03B 41/00**

(21) Application number: 84306894.1

(22) Date of filing: 10.10.84

(54) Photomask pattern inspection.

(30) Priority: 13.10.83 JP 191618/83

(43) Date of publication of application:
15.05.85 Bulletin 85/20

(45) Publication of the grant of the patent:
08.01.92 Bulletin 92/02

(84) Designated Contracting States:
DE FR GB

(56) References cited:
US-A- 4 388 386

PATENT ABSTRACTS OF JAPAN, vol. 6, no.
247 (E-146)[1125], 7th December 1982; & JP-
A-57 148 347

(73) Proprietor: **FUJITSU LIMITED**
**1015, Kamikodanaka Nakahara-ku**
**Kawasaki-shi Kanagawa 211(JP)**

(72) Inventor: **Matsuyama, Takayoshi C/O FUJITSU**
**LIMITED**
**Patent Department 1015 Kamikodanaka**
**Nakahara-ku Kawasaki-shi Kanagawa 211(JP)**
Inventor: **Kobayashi, Kenichi C/O FUJITSU**
**LIMITED**
**Patent Department 1015 Kamikodanaka**
**Nakahara-ku Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

Note: Within nine months from the publication of the mention of the grant of the European patent, any person
may give notice to the European Patent Office of opposition to the European patent granted. Notice of opposition
shall be filed in a written reasoned statement. It shall not be deemed to have been filed until the opposition fee
has been paid (Art. 99(1) European patent convention).

## Description

The present invention relates to photomask pattern inspection, that is, to a method and apparatus for inspecting a photomask pattern for example for use in the fabrication of a semiconductor device such as a semiconductor integrated circuit (IC) or a large scale semiconductor integrated circuit (LSI).

First, brief explanations will be given of requirements which must be met by a photomask pattern and of fabrication of a photomask pattern.

A plurality of photomask patterns are required for fabricating a semiconductor device. The semiconductor device is fabricated on a semiconductor wafer through a series of repeated printing and etching steps in accordance with a plurality of photomask patterns. Each photomask pattern is required to consist of a plurality, several thousands for example, of unit patterns for semiconductor dies, each having the same shape and size, for the mass production of semiconductor devices from a wafer having a size as large as five inches diameter or more. The photomask pattern must be tremendously complicated in order to achieve high packing density of semiconductor circuits. Thus, high accuracy, on the order of a micron, is required of the photomask pattern.

A photomask is made of a glass plate coated with optically sensitive material, called a sensitive plate. The plurality of unit patterns are "printed" on the photomask by step and repeat exposures of an optical image from an original unit pattern. For this purpose the photomask is mounted on a stage and the fabrication of the photomask pattern can be effected by shifting the stage in step and repeat movements with respect to a fixed optical system for exposing the photomask to the optical image.

As mentioned above, a photomask is very important in the fabrication of a semiconductor device. The photomask must be inspected very carefully to ensure that the photomask pattern fabricated thereon is suitable for use.

In particular great attention must be paid to irregularities in the photomask pattern on the photomask. If irregularity is present in the photomask pattern, use of the photomask in one of the series of printing steps, using many photomasks overall, for fabricating semiconductor devices on a wafer will result in incorrect printing on the wafer.

Therefore, after every fabrication of a photomask, the photomask pattern must be inspected to ensure that such incorrect printing will not occur if the pattern is used for semiconductor device fabrication. In particular, printing of the unit patterns in correct positions is very important to avoid wasting time in semiconductor device production. Thus, it is important to inspect the photomask pattern for correct unit pattern positioning.

Previously inspection has been carried out by a human inspector using a microscope to observe vernier patterns provided at the side edges of each unit pattern (generally unit patterns have had a four-sided shape). Ideally vernier patterns of neighbouring unit patterns should be exactly adjacent each other. That is, there should ideally be no shear or displacement between adjacent vernier patterns. Previously the inspector has had to observe the vernier patterns and take measurements of amounts of shear actually present to determine whether or not adjacent unit patterns are arranged within allowable limits.

However, there are so many unit patterns on a photomask that a great deal of time is required to observe all of the vernier patterns on a photomask. For example, if the total number of unit patterns on a photomask is 5,000 and it takes 20 seconds to check one vernier pattern, it will take more than 15 hours of continuous observation to inspect one photomask. In practice, of course, observation cannot be carried out continously for such a length to time. Intervals must be allowed so actual time needed would be much longer.

Thus, in reality, only several (spaced) skipped points of a photomask pattern are inspected ("sampling" inspection) to reduce inspecting time to several minutes.

However, as packing density of semiconductor devices increases, more accuracy, e.g. as less than one micron, is required. To achieve this, "sampling" inspection as mentioned above is inadequate; inspection of whole (all) unit patterns becomes necessary.

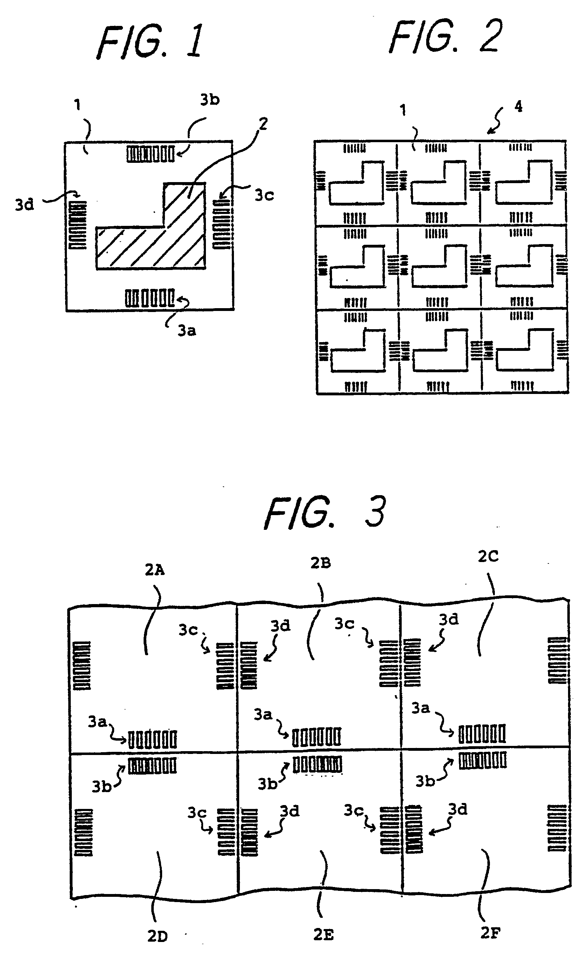

Fig. 1 shows schematically an example of an original unit pattern having vernier patterns as previously provided, Fig. 2 shows schematically an example of a photomask pattern on which the original unit pattern of Fig. 1 is printed repeatedly and Fig. 3 is an enlarged view showing parts of the vernier patterns on the photomask pattern of Fig. 2.

An original unit pattern 1 as seen in Fig. 1 has a die pattern 2 in a middle part of the unit pattern and four vernier patterns (only schematically shown in Figs. 1 to 3) 3a, 3b, 3c and 3d near by the four side edges of the unit pattern. The original unit pattern 1 is repeatedly printed on a sensitive plate to provide a photomask pattern 4 as shown in Fig. 2. As mentioned above, the printing is effected by shifting a stage in a step and repeat movement. This movement is very carefully controlled, but slight errors are unavoidable, so respective pitches between neighboring unit patterns in latitudinal and longitudinal directions cannot always be made equally. Of course, some amount of pitch error will be allowable or tolerable, depending on the features of the photomask pattern. The vernier patterns are provided to allow measurements to determine whether shear existing in the arrangement of unit patterns is within allowed limits. This measurement is made by the inspector observing the vernier patterns in a microscope. In Fig. 3, 2A, 2B, 2C, 2D, 2E and 2F are the unit patterns, the combination of adjacent patterns 3a and 3b in unit patterns forms a vernier measurement pattern. If the readings of the respective vernier measurement patterns are within a designated allowance, it can be judged that the latitudinal arrangement of the unit patterns is good. The same inspection can be made with respect to the longitudinal arrangement by observing longitudinal vernier measurement patterns formed by patterns 3c and 3d in the unit patterns. Such observation takes up a great deal of labour and time, and moreover involves a risk of damage to or of dust adhering to the photomask pattern.

Thus, the previous inspection method has involved a human inspector observing the vernier patterns and taking readings or measurements of amounts of shear from those patterns. This is labourious and expensive and involves additional risks as mentioned above.

According to the present invention there is provided a method of inspecting the arrangement of unit patterns on a photomask, in which there are printed on the photomask, in the unit patterns, shear-detecting-patterns such that adjacent shear-detecting-patterns, belonging to respective adjacent unit patterns, provide combined-patterns, which combined-patterns provide one or more groups of combined-patterns such that within a group the combined-patterns are all similar in the case of acceptable printing of unit patterns on the photomask,

and comprising:-

designating one combined-pattern of a group as a standard-pattern,

comparing the standard-pattern with another combined-pattern of the group,

on the basis of the comparison, providing a difference amount representative of difference between the compared patterns,

designating a maximum allowable difference amount level, and

determining that unacceptable printing of unit patterns on the photomask has been effected when the difference amount exceeds the maximum allowable difference amount level.

An inspection method embodying the present invention involves pattern comparison, and the previously necessary observation of vernier patterns and measurement of shears by a human inspector is unnecessary.

For inspection in accordance with an embodiment of the present invention, shear-detecting-patterns are printed generally similarly to the previously used vernier patterns. However these shear-detecting-patterns need not be vernier patterns, it is sufficient for them to be such that in a group of combined-patterns, each combined pattern provided by a pair of adjacent shear-detecting-patterns, all the combined-patterns will be the same shape and size in the case of a correct unit pattern arrangement. For example it is sufficient for the shear-detecting-patterns all to be of the same shape and size.

In an inspection method embodying the present invention, at the beginning of the inspection, one combined-pattern in a group of combined-patterns (for instance a group pertaining to the latitudinal direction of a photomask pattern, or a group pertaining to the longitudinal direction) all (ideally, in the case of a correct unit pattern arrangement) of the same shape and size is designated as a standard-pattern for comparison with the other combined-patterns of the group. This designation can be easily determined by skilled art inspecting.

An optical image of each combined-pattern in a group is taken out and converted into electrical signals. The electrical signals are divided so that signals representing the standard-pattern and signals representing another combined-pattern in the group are stored in respective memories. The stored signals are read out and compared with one another.

Similarly, comparisons are effected in relation to other groups of combined-patterns on the photomask and if there are special deviated-shears in the photomask pattern, this can be detected and information concerning irregular arrangement of the unit patterns can be obtained from the comparisons.

With the present invention, an embodiment can be provided in which inspection of all combined-patterns provided when the number of unit patterns is more than 5,000 can be carried out in a short time of as little as 30 minutes, reducing labour and time taken for inspection, and problems such as damage to the photomask pattern and sticking of dust to the photomask pattern can be avoided.

Reference is made, by way of example, to the accompanying drawings, in which:

Fig.1 schematically illustrates an original unit pattern having vernier patterns as previously employed,

Fig.2 schematically illustrates a photomask pattern including a plurality of unit patterns as shown in Fig.1,

Fig.3 is a schematic diagram illustrating in more detail adjacent vernier patterns in the photomask pattern of Fig.2,

Fig.4 provides schematic diagrams illustrating shear-detecting-patterns and combined-patterns as used in an embodiment of the present invention, the shear-detecting-patterns being arranged for detecting latitudinal shear, diagram (a) shows normally (ideally) arranged combined-patterns, diagram (b) shows combined-patterns having equal amounts of shear, and diagram (c) shows a case in which amounts of shear deviate from one combined-pattern to another,

Fig.5 is a schematic diagram illustrating a part of a photomask pattern on which plurality of unit patterns which have suffered image rotation are printed, and

Fig.6 is a schematic block diagram of apparatus embodying the present invention.

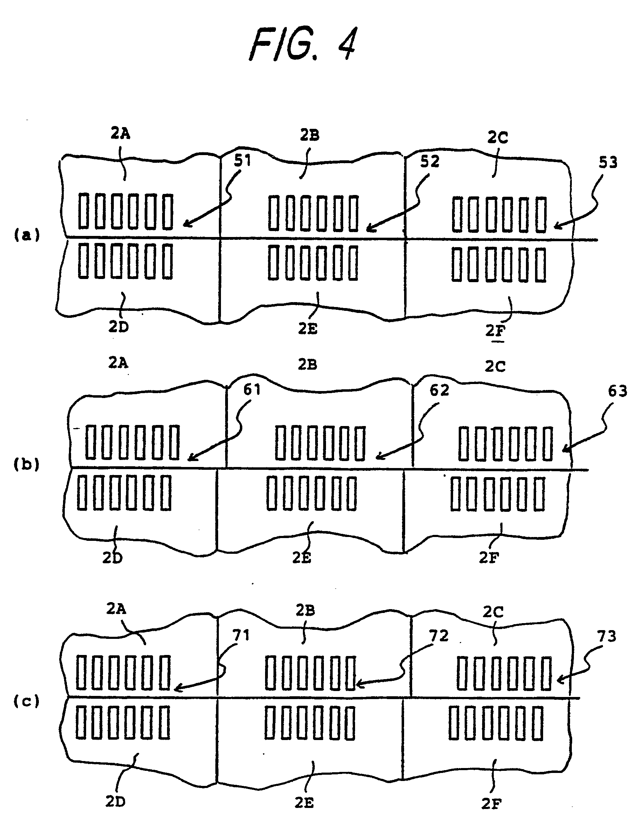

In Fig. 4, diagrams (a), (b) and (c) illustrate respective arrangements of shear-detecting-patterns and combined-patterns which may be encountered in inspections of photomask patterns in accordance with an embodiment of the present invention.

In each of the diagrams of Fig. 4, 2A to 2F are neighbouring unit patterns (each only partially shown) provided in a photomask pattern on a photomask. Each unit pattern in this case has four sides and a shear-detecting-pattern is provided near the side edge at each side of the unit pattern, in accordance with this embodiment of the present invention.

In the diagrams of Fig. 4, the shear-detecting-patterns at the bottom sides of unit patterns 2A, 2B, 2C can be seen, and the shear-detecting patterns at the top sides of unit patterns 2D, 2E and 2F can be seen.

The shear-detecting-patterns are all of the same shape and size, in this case. It is to be noted, however, that the shear-detecting-patterns need not be vernier patterns.

In Fig. 4, combined-patterns as mentioned above are seen at 51,52,53 in diagram (a), at 61,62,63 in diagram (b) and at 71,72,73 in diagram (c). Each combined pattern is formed by a pair of adjacent shear-detecting-patterns belonging to different (adjacent) unit patterns.

The combined-patterns 51,52,53 in diagram (a) are all members of one group of combined-patterns in which, ideally (i.e. in the case of a correct unit pattern arrangement), all the combined patterns are of the same shape and size.

Similarly, combined-patterns 61,62,63 in diagram (b) are members of one group, and combined-patterns 71,72,73 in diagram (c) are members of one group.

In a method of inspection embodying the present invention the combined-patterns in a group are subject to comparisons one with another. One combined-pattern in a group is designated a standard combined-pattern and each other combined-pattern in the group is compared with the standard pattern to detect differences i.e. to detect a deviated pattern not conforming to the standard-pattern. Of course, all combined patterns in a group should conform to the standard pattern, being of equal shape and size.

In diagram (a) of Fig.4 the unit patterns are correctly arranged, so if a combined-pattern 51 is designated as a standard-pattern and the other combined-patterns 52 and 53 are respectively compared with the standard-pattern 51, "no difference" will be obtained as the result of the comparison.

The same result will be obtained with the arrangement of diagram (b) if combined-pattern 61 is designated as standard-pattern.

However, in the case of diagram (c), when combined-pattern 72 is designated as standard-pattern, the result of comparison between the standard-pattern 71 and combined-pattern 72 will be acceptable (i.e. "no difference"), but the result of comparison between standard-pattern 71 and the combined-pattern 73 will indicate a difference, i.e. that combined-pattern 73 is unacceptable or a deviated-pattern.

It will be understood that the pattern comparisons do not involve the taking of measurements of shear amounts and do not require the use of vernier patterns for that purpose. Thus, the need for a human inspector to carry out such observations and measurements is avoided.

Fig.4 shows the combined-patterns arranged in a latitudinal direction of a photomask pattern, but detection of a deviated-pattern can be similarly carried out in respect of the longitudinal arrangement of combined-patterns.

It will be noted that the arrangement of diagram (a) of Fig. 4, which corresponds to an ideal arrangement of unit patterns with adjacent shear-detecting-patterns exactly aligned, will be judged to be a correct or acceptable arrangement and that the arrangement of diagram (b), having a constant amount of shear or displacement between adjacent shear-detecting patterns, will also be judged correct or acceptable. Only the arrangement of diagram (c), with different or deviated amounts of shear or displacement, will be judged incorrect.

With the previous inspection method, using vernier measurement of amounts of shear, the arrangement of diagram (b) would be judged to be an incorrect (i.e. have incorrect printing pitch) with the constant amount of shear measured as being greater than some allowable maximum amount.

However, the inventors have determined that measurement or detection of a constant (absolute) amount of shear is unnecessary. They have determined that it is sufficient to detect only deviated shear, corresponding to a deviated-pattern such as combined-pattern 73 in diagram (c) of Fig. 4.

Deviated-shear it will be understood, refers to the occurrence of a different type of amount of shear from the shear of a "normal" unit pattern arrangement, e.g. a change in relative shear amount.

The inventors believe that this can be understood on the basis of the following explanation.

From investigations, the inventors have determined that irregular printing of unit patterns on a photomask pattern has two primary causes:-

irregular shifting of the stage caused by the mechanism for effecting step and repeat movements; and

image rotation caused by rotated setting of the optical system relative to the coordinates of the stage movement.

Now, a plurality of photomasks are required for the fabrication of a semiconductor device from a wafer. However, if the photomask patterns are produced on all the photomasks by the same fabricating machine, patterns on the photomasks will all in general have the same overall printing shear. It can thus be understood that such constantly present, consistent, amounts of shear should pose little or no problem, so only deviated-shear, (the presence of a different type or amount of shear on the photomask) should lead to rejection on inspection.

Shears produced on a photomask by irregular shifting of the stage tend to occur in an equal amounts along an array of unit patterns (e.g. along a line of unit patterns extending in one direction of shifting of the stage), because the stage can be smoothly shifted repeatedly along a direction of the array (a latitudinal direction for example), but when the stage steps toward another direction (a longitudinal direction for example) to print a next array, there are cases where the positioning of the stage produces a slight shear due to (mis)-operation of the stage stepping mechanism.

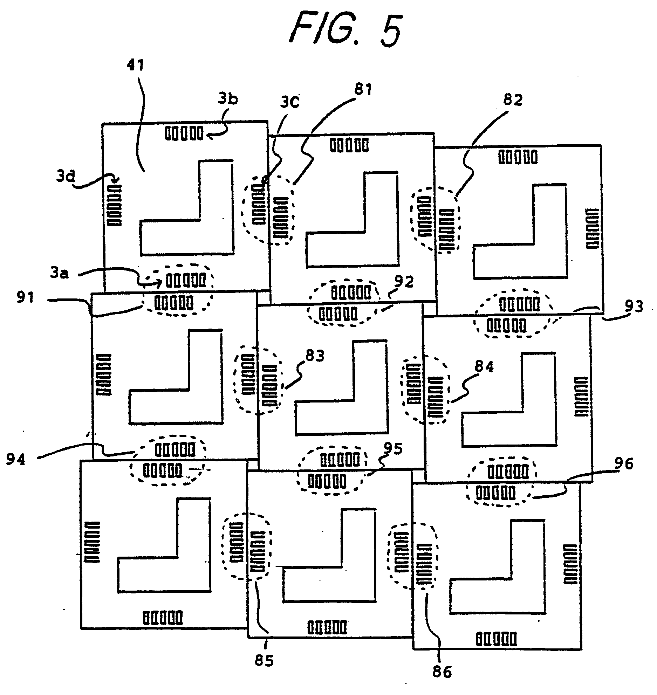

Shears produced by image rotation obviously occur in equal amounts for all unit patterns. This will be explained in more detail hereinafter with reference to Fig.5.

Therefore, it can be said that there is no room to produce the deviated-shear in the normal printing; the measurement of the shear amount becomes unnecessary.

That is, measurement of shear amount is not necessary because although amounts of shear may be present, provided the amount of shear is uniform this does not mean that the photomask pattern is unsuitable for use in a series of steps, using many photomasks, for fabricating a semiconductor device. The important factor, the inventors have concluded, is deviated-shear as explained above.

Inspection in accordance with the present invention can be achieved without the need for a human inspector to carry out observations and measurements of shear amounts as has been necessary previously in photomask inspection. A comparison technique is employed using shear-detecting-patterns (for example four) marked on each unit pattern similarly to the vernier patterns of the previous inspection method. These shear-detecting-patterns need not be vernier patterns. A pair of shear-detecting-patterns adjacent to each other is the object of comparison and such a pair is called a combined-pattern.

Fig.5 shows a part of a photomask pattern consisting of adjacent unit patterns each having suffered image rotation in printing. Each unit pattern suffers the same amount of image rotation.

In Fig. 5, each unit pattern, for example, a unit pattern 41 has, in accordance with an embodiment of the present invention, four shear-detecting-patterns 3a, 3b, 3c, and 3d; a pair of shear-detecting-patterns which are adjacent to each other provides a combined-pattern as explained above and as indicated by broken-line rings 81 to 92 in Fig.5. Combined-patterns indicated by rings 81,82,83, 84, --- belong to one group, and combined-patterns 91,92,93,94,95 --- belong another group. It will be understood that within each group the combined-patterns should all be of the same shape and size, since amounts of shear should all be equal, so that the pattern comparison technique of the present invention can be applied to each group to detect deviated-shear.

The combined-patterns can be compared and deviated-shear can be detected automatically in accordance with the present invention.

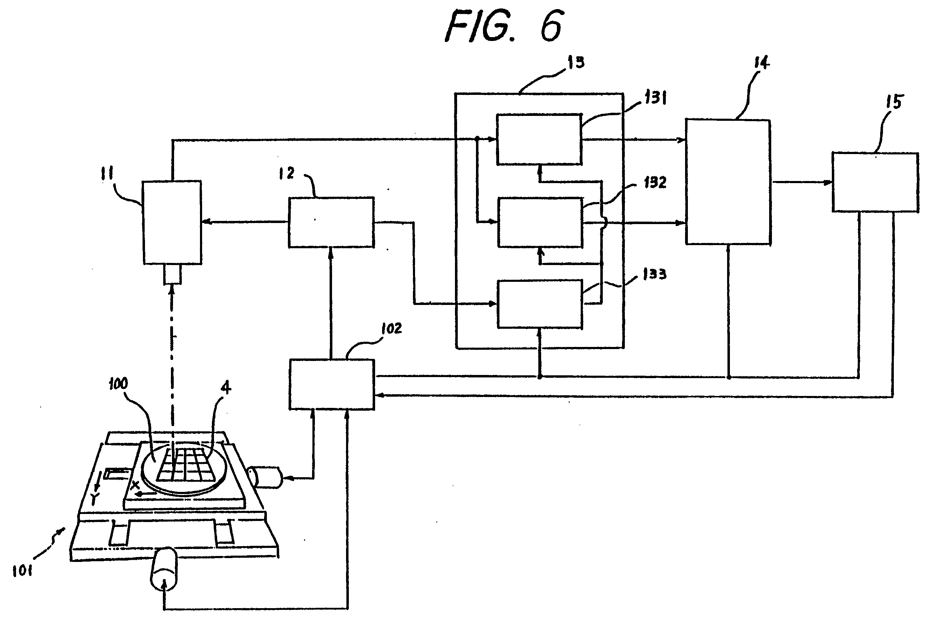

Fig.6 is a schematic block diagram of inspecting apparatus embodying the present invention.

In Fig. 6, photomask 100 on which a photomask pattern 4 has been printed is mounted on a stage 101 for inspection. The stage 101 consists of moving parts which shift the photomask 100 in X and/or Y directions with a step and repeat movement which is controlled by a stage controller 102.

An image sensor 11 optically and sequentially takes out optical images of combined-patterns (as explained above ) from the photomask pattern 4. Such an optical image is provided by optical scanning or electrical scanning of sensing elements, and the scan is controlled by a scan controller 12. The optical image has a resolution sufficient for detection of detail of the combined-patterns. The optical image is converted to electrical signals by the image sensor 11; the electrical signals are produced in company with address signals relating to a matrix of the optical image; the address signals are provided by the scan controller 12.

The converted electrical signals and the accompanying address signals go into a memory unit 13 which consists of a standard-pattern memory or memory part 131, a usual-pattern memory or memory part 132, and a memory controller 133. Electrical signals stored in the standard-pattern memory 131 correspond to signals from the designated standard-pattern of a group of the combined-patterns each ideally having same shape and size. Electrical signals stored in the usual-pattern memory 132 correspond to signals from another combined-pattern of the same group. The signals corresponding to the standard-pattern function as a standard for comparison with the signals corresponding to each of the other combined-patterns in the same group of combined-patterns.

More detail will be given with reference to Fig.5. It will be clear from Fig.5 that combined-patterns 81,82,83,84,85, and 86 should (ideally and despite the image rotation) all be the same; that is, they form one group to be called the first group. It will also be clear that the combined patterns 91,92,93,94,95, and 96 similarly form another group to be called the second group. So, in each group any one combined-pattern can be designated a standard pattern for the group : for example combined-patterns 81 and 91 can be designated as standard-patterns for the first and second groups respectively. Therefore, stage movement for allowing comparisons in accordance with an embodiment of the present invention can be planned as follows: first, the stage shifts to compare each combined-pattern in first group with the standard-pattern 81 in order of patterns 82,83,84,85,86 and so on; second, the stage shifts to compare each combined-pattern in second group with the standard-pattern 91 in the order of patterns 92,83,94,95, 96, and so on. Designations of standard patterns and orders of stage movement can be previously determined and set in an inspecting program which may be provided in the stage controller 102; this programming can be done by those skilled in the art of inspecting.

Following the program, the stage controller 102 shifts the stage 101; the scan controller 12 controls the image sensor to form an optical image and sends address signals to the memory controller 133; the memory controller 133 controls the standard-pattern memory 131 and the usual-pattern memory 132 to write in and read out the electric signals from the standard-pattern and another combined-pattern in a group. The read-out signals are sent to a comparator 14 in which the signals corresponding to the standard-pattern and to the other combined-pattern are compared and which produces a difference amount on the basis of the comparison. An allowable maximum difference amount level is specified according to the features (detail) of the photomask pattern in the comparator 14, and the difference produced is compared with this level. If the difference amount exceeds this level, the comparator outputs the information that the photomask has an incorrect arrangement of the unit patterns. This output goes to an output terminal 15 at which the information is displayed and/or recorded to indicate the location of an incorrect part of the photomask pattern. When the inspection of a group of combined patterns is over, inspection is repeated changing to a next group until another incorrect part is found; this repeat can be also effected by the program.

Vernier patterns as have been previously employed for inspection purposes can be used in the present invention. However, if the pattern is newly required to provide, the shear-detecting-pattern as mentioned above is enough; in other words there is no necessity to use vernier patterns.

Consequently, applying the present invention, the locations of all unit patterns on the photomask can be completely inspected without observation and measurement by a human inspector. Applying the present invention, inspection time can be reduced to as little as 30 minutes for a photomask pattern having 5,000 unit patterns for example, even though the inspection is complete for all unit patterns.

It will be understood that with a photomask pattern as seen in Fig. 5, the previous "vernier" inspection method would judge that the pattern was incorrect (incorrect printing pitch), leading in this case to rejection of the photomask, with the amount of constant shear present greater than a designated allowable amount. With the present invention, however, in the absence of deviated-shear, the photomask pattern of Fig. 5 is judged good, since all the shears of all the unit patterns is the same. Thus unnecessary wastage is avoided, in addition to the savings in inspection time and labour provided by the present invention.

Embodiments of the present invention provide method and apparatus for inspecting the arrangement of unit patterns, each having the same shape and size, printed repeatedly ideally with equal intervals on a photomask. Shear-detecting-patterns are printed in each unit pattern which form combined-patterns on the photomask which combined-patterns form groups in which all the combined-patterns should have the same shape and size. Even when shears appear in the combined-patterns, if the shears are equal, the arrangement of unit patterns involved is judged still to be acceptable. This means that a pattern comparison can be applied as the basis of the inspection method of the present invention. Designating a standard-pattern from the combined-patterns in a group, comparison between each other combined-pattern in the group and the standard-pattern is made. Optical images of the combined-patterns in a group are taken from the photomask one by one and converted into electric signals. The signals corresponding to the standard-pattern and to other combined patterns are divided and stored in respective memories. These signals are read out and compared with each other to provide an amount of difference. Comparing the level of this amount with an allowance level provided previously, the combined-pattern arrangement in the group is determined to be correct or incorrect. By repeating such comparisons for other groups, the unit pattern arrangement on the photomask can be determined to be correct or incorrect.

In an embodiment of the present invention all the shear-detecting-patterns provided may be the same. That is, in the usual case of four sided unit patterns, four shear-detecting-patterns provided respectively at the four side edges of each unit pattern may all be the same.

However, it will be appreciated that the important factor is to provide shear-detecting-patterns such that within a group of combined-patterns (e.g. a group pertinent to longitudinal arrangement of unit patterns or a group pertinent to latitudinal arrangement of unit patterns) all the members of the group should ideally (in the case of acceptable printing) be the same.

It will be noted that with an embodiment of the present invention which provides for inspection in relation to every unit pattern of a photomask pattern, incorrect printing locations can be identified (e.g. when a standard-pattern as mentioned above is selected to correspond to a location of correct printing). This means that the photomask can still be used for semiconductor device fabrication (provided the number of incorrect printing locations is not too high) because the locations of incorrect devices on a finished wafer will be known and devices from these locations can be selectively rejected.

With the previous "sampling" inspection this, of course, would not be possible.

## Claims

1. A method of inspecting the arrangement of unit patterns (2A to 2F; 41) on a photomask, in which there are printed on the photomask, in the unit patterns, shear-detecting-patterns (3a, 3b, 3c, 3d) such that adjacent shear-detecting-patterns, belonging to respective adjacent unit patterns, provide combined-patterns (51 to 53; 61 to 63; 71 to 73; 81 to 86; 91 to 96), which combined-patterns provide one or more groups of combined-patterns such that within a group the combined-patterns are all similar in the case of acceptable printing of unit patterns on the photomask,

and comprising:-

designating one combined-pattern (51; 61, 71; 81; 91) of a group as a standard-pattern,

comparing the standard-pattern with another combined-pattern of the group (52, 53; 62, 63; 72, 73; 82 to 86; 91 to 96),

on the basis of the comparison, providing a difference amount representative of difference between the compared patterns,

designating a maximum allowable difference amount level, and

determining that unacceptable printing of unit patterns on the photomask has been effected when the difference amount exceeds the maximum allowable difference amount level.

2. A method as claimed in claim 1, wherein the shear-detecting-patterns are provided in each unit pattern at respective side edges of the unit pattern, and each combined-pattern is provided by adjacent shear-detecting-patterns, at respective mutually adjacent edges of adjacent unit patterns.

3. A photomask having unit patterns printed thereon which include shear-detecting-patterns, or an original unit pattern which includes shear-detecting-patterns, for use in a method as claimed in claim 1 or claim 2, said shear-detecting-patterns being arranged on each side of a unit pattern and each having an equal shape and size and being printed near an edge of each pattern side.

## Revendications

1. Procédé d'inspection de l'agencement de motifs unitaires (2A à 2F ; 41) sur un photomasque, dans lequel sont imprimés sur le photomasque, dans les motifs unitaires, des motifs de détection de cisaillement (3a, 3b, 3c, 3d) de telle sorte que des motifs de détection de cisaillement adjacents qui appartiennent à des motifs unitaires adjacents respectifs constituent des motifs combinés (51 à 53 ; 61 à 63 ; 71 à 73 ; 81 à 86 ; 91 à 96), ces motifs combinés constituant un ou plusieurs groupes de motifs combinés de telle sorte qu'à l'intérieur d'un groupe, les motifs combinés soient tous similaires dans le cas d'une impression acceptable de motifs unitaires sur le photomasque,

et comprenant :

la désignation d'un motif combiné (51 ; 61 ; 71 ; 81 ; 91) d'un groupe en tant que motif standard ;

la comparaison du motif standard avec un autre motif combiné du groupe (52, 53 ; 62, 63

; 72, 73 ; 82 à 86 ; 91 à 96) ;

   sur la base de la comparaison, la fourniture d'une valeur de différence qui représente la différence entre les motifs comparés ;

   la désignation d'un niveau de valeur de différence maximale permis ; et

   la détermination qu'une impression inacceptable de motifs unitaires sur le photomasque a été effectuée lorsque la valeur de différence excède le niveau de valeur de différence maximale permis.

2. Procédé selon la revendication 1, dans lequel les motifs de détection de cisaillement sont prévus dans chaque motif unitaire au niveau des bords latéraux respectifs du motif unitaire et dans lequel chaque motif combiné est constitué par des motifs de détection de cisaillement adjacents, au niveau de bords mutuellement adjacents respectifs de motifs unitaires adjacents.

3. Photomasque comportant des motifs unitaires imprimés qui incluent des motifs de détection de cisaillement ou un motif unitaire original qui comporte des motifs de détection de cisaillement, destiné à être utilisé dans un procédé selon la revendication 1 ou 2, lesdits motifs de détection de cisaillement étant agencés sur chaque côté d'un motif unitaire, chacun ayant une forme et une taille égales et étant imprimé en arrière d'un bord de chaque côté du motif.

**Patentansprüche**

1. Verfahren zum Inspizieren der Anordnung von Einheitsmustern (2A bis 2F; 41) auf einer Fotomaske, bei welchem auf der Fotomaske, in den Einheitsmustern, Scher-Detektionsmuster (3a, 3b, 3c, 3d) gedruckt sind, so daß aneinander angrenzende Scher-Detektionsmuster, die zu entsprechenden angrenzenden Einheitsmustern gehören, Kombinationsmuster (51 bis 53; 61 bis 63; 71 bis 73; 81 bis 86; 91 bis 96) bilden, welche Kombinationsmuster eine oder mehrere Gruppen von Kombinationsmustern bilden, so daß innerhalb einer Gruppe der Kombinationsmuster alle ähnliche sind, in dem Fall eines akzeptablen Druckens von Einheitsmustern auf die Fotomaske,

   und mit:-

   Designieren eines Kombinationsmusters (51; 61, 71; 81; 91) von einer Gruppe von Standardmustern,

   Vergleichen des Standardmusters mit einem anderen Kombinationsmuster der Gruppe (52, 53; 62, 63; 72, 73; 82 bis 86; 91 bis 96),

   auf der Basis des Vergleichs, und der Vorsehung eines Differenzbetrages, der eine Differenz zwischen den verglichenen Mustern darstellt,

   Designieren eines maximal zulässigen Differenzbetragpegels, und

   Bestimmen, daß unakzeptables Drucken von Einheitsmustern auf der Fotomaske bewirkt worden ist, wenn der Differenzbetrag den maximal zulässigen Differenzbetragpegel übersteigt.

2. Verfahren nach Anspruch 1, bei dem die Scher-Detektionsmuster in jedem Einheitsmuster an entsprechenden Seitenrändern des Einheitsmusters vorgesehen sind, und jedes Kombinationsmuster durch angrenzende Scher-Detektionsmuster an entsprechend wechselseitig aneinander angrenzenden Rändern von benachbarten Einheitsmustern vorgesehen ist.

3. Fotomaske mit darauf gedruckten Einheitsmustern, welche Scher-Detektionsmuster enthalten, oder ein Original-Einheitsmuster, welches Scher-Detektionsmuster enthält, zur Verwendung bei einem Verfahren nach Anspruch 1 oder 2, welche Scher-Detektionsmuster an jeder Seite des Einheitsmusters angeordnet sind, und jeweils eine gleiche Form und Größe haben und nahe einem Rand von jeder Musterseite gedruckt sind.

## FIG. 1

## FIG. 2

## FIG. 3

# FIG. 4

# FIG. 5

FIG. 6

EP 0 141 548 B1